(19) Europäisches Patentamt / European Patent Office / Office européen des brevets

(11) **EP 4 001 934 B1**

(12) **FASCICULE DE BREVET EUROPEEN**

(45) Date de publication et mention de la délivrance du brevet:
**16.10.2024 Bulletin 2024/42**

(21) Numéro de dépôt: **21206677.3**

(22) Date de dépôt: **05.11.2021**

(51) Classification Internationale des Brevets (IPC):
**G01R 31/08** (2020.01)     **G01R 31/11** (2006.01)

(52) Classification Coopérative des Brevets (CPC):
**G01R 31/088; G01R 31/11;** G01R 27/06;
G01R 27/32

(54) **MÉTHODE DE CARACTÉRISATION D'UNE LIGNE DE TRANSMISSION PAR SON PROFIL D'IMPÉDANCE CARACTÉRISTIQUE**

METHODE ZUR CHARATERISIERUNG EINER ÜBERTRAGUNGSLEITUNG BASIEREND AUF IHREM IMPEDANZPROFIL

METHOD OF CHARACTERISING A TRANSMISSION LINE BASED ON ITS IMPEDANCE PROFILE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.11.2020 FR 2011645**

(43) Date de publication de la demande:
**25.05.2022 Bulletin 2022/21**

(73) Titulaire: **Commissariat à l'Énergie Atomique et aux Énergies Alternatives 75015 Paris (FR)**

(72) Inventeur: **COHEN, Josy 91191 GIF-SUR-YVETTE (FR)**

(74) Mandataire: **Atout PI Laplace Immeuble Up On 25 Boulevard Romain Rolland CS 40072 75685 Paris Cedex 14 (FR)**

(56) Documents cités:
EP-A1- 3 014 778        EP-A1- 3 186 647
EP-A2- 1 477 820        EP-B1- 3 014 778
EP-B1- 3 186 647        FR-A1- 2 964 746
FR-A1- 3 034 203        US-A- 5 128 619
US-A- 5 352 984        US-A1- 2005 234 661
US-A1- 2019 162 772

• AGILENT APPLICATION NOTE 1304-5: "Improving TDR/TDT Measurements Using Normalization", INTERNET CITATION, 1 January 2001 (2001-01-01), pages 1 - 14, XP002552344, Retrieved from the Internet <URL:http://cp.literature.agilent.com/litweb/pdf/5988-2490EN.pdf> [retrieved on 20091026]
• CHANG SEUNG JIN: "Advanced Signal Sensing Method With Adaptive Threshold Curve Based on Time Frequency Domain Reflectometry Compensating the Signal Attenuation", IEEE OPEN JOURNAL OF THE INDUSTRIAL ELECTRONICS SOCIETY, IEEE, vol. 1, 13 February 2020 (2020-02-13), pages 22 - 27, XP011782752, DOI: 10.1109/OJIES.2020.2973881

## Description

L'invention concerne le domaine des systèmes et procédés de diagnostic de l'état de santé d'un câble ou plus généralement d'une ligne de transmission. Elle entre dans le champ des méthodes de diagnostic par réflectométrie qui visent à détecter et localiser des défauts électriques sur un câble ou à évaluer un niveau de dégradation ou de vieillissement de ce câble. Dans ce contexte, les documents FR 2 964 746 A1, US 2005/234661 A1, EP 1 477 820 A2 présentent des exemples pertinents d'approches de caractérisation de lignes de transmission.

L'invention porte plus précisément sur une méthode de caractérisation d'une ligne de transmission qui vise à déterminer son profil d'impédance caractéristique en vue d'exploiter cette information pour analyser l'état de santé de la ligne.

L'invention s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées, en toron de câble ou autre. L'invention peut également s'appliquer à des câbles mécaniques, par exemple des câbles de soutien d'infrastructures telles un ascenseur ou un pont.

Selon un principe connu, les méthodes dites de réflectométrie sont utilisées pour détecter et/ou localiser des défauts électriques ou mécaniques qui engendrent des discontinuités ou des ruptures d'impédance dans un câble.

Ces méthodes utilisent un principe proche de celui du radar : un signal électrique, souvent de haute fréquence ou large bande, est injecté en un ou plusieurs endroits du câble à tester. Le signal se propage dans le câble ou le réseau et renvoie une partie de son énergie lorsqu'il rencontre une discontinuité électrique. Une discontinuité électrique peut résulter, par exemple, d'un branchement, de la fin du câble ou plus généralement d'une rupture des conditions de propagation du signal dans le câble. Elle résulte le plus souvent d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

Un problème général visé par l'invention consiste à pouvoir caractériser précisément l'impédance caractéristique d'une ligne de transmission en différents points de cette ligne afin d'identifier la nature de potentiels défauts présents sur cette ligne.

Cette caractérisation est difficile à réaliser avec des méthodes classiques du fait des réflexions multiples du signal injecté dans la ligne sur les différentes interfaces générées par des discontinuités d'impédance.

Les références [1] et [2] décrivent des méthodes de diagnostic pour caractériser des défauts de natures diverses. Ces méthodes nécessitent des moyens de calcul importants et ne permettent pas de déterminer précisément le profil d'impédance caractéristique du câble à analyser.

Par ailleurs, la demande de brevet français du Demandeur publiée sous le numéro FR 3034203 décrit une méthode permettant de déterminer l'impédance caractéristique d'un ou de plusieurs connecteurs reliant un équipement de mesure à un câble à diagnostiquer.

L'invention propose une méthode de traitement d'un réflectogramme acquis selon une méthode de réflectométrie temporelle ou fréquentielle, permettant de déterminer un profil d'impédance caractéristique d'un câble sur toute sa longueur. Plus généralement, l'invention est applicable à tout type de signal de réflectométrie, notamment des signaux multi-porteuses de type OMTDR (Orthogonal MultiTone Time Domain Reflectometry) ou MCTDR (MultiCarrier Time Domain Reflectometry).

L'invention a pour objet une méthode de caractérisation d'une ligne de transmission selon la revendication 1.

Dans une variante de réalisation, la méthode selon l'invention comprend en outre une étape de filtrage de la réponse impulsionnelle au moyen d'une comparaison de chaque pic à un seuil prédéterminé.

Dans une variante de réalisation, la méthode selon l'invention comprend en outre une étape de déconvolution appliquée à la réponse impulsionnelle.

Dans une variante de réalisation, la méthode selon l'invention comprend en outre une étape de caractérisation d'un défaut associé à au moins une discontinuité d'impédance à partir de son impédance caractéristique.

Dans une variante de réalisation, la méthode selon l'invention comprend en outre une étape de détermination d'une variation continue d'impédance caractéristique le long de la ligne de transmission, à partir des impédances caractéristiques déterminées et d'un modèle.

L'invention a aussi pour objet un programme d'ordinateur comportant des instructions pour l'exécution de la méthode de caractérisation d'une ligne de transmission selon l'invention, lorsque le programme est exécuté par un processeur.

L'invention a aussi pour objet un support d'enregistrement lisible par un processeur sur lequel est enregistré un programme comportant des instructions pour l'exécution de la méthode de caractérisation d'une ligne de transmission selon l'invention, lorsque le programme est exécuté par un processeur.

L'invention a aussi pour objet un système de caractérisation d'une ligne de transmission comprenant un générateur de signal de référence configuré pour injecter un signal de référence dans une ligne de transmission en un point d'injection, un équipement de mesure configuré pour mesurer le signal rétro-propagé en un point de mesure et une unité de traitement configurée pour exécuter les étapes de la méthode selon l'invention.

D'autres caractéristiques et avantages de la présente invention apparaîtront mieux à la lecture de la description qui suit en relation aux dessins annexés suivants.

[Fig. 1] la figure 1 représente un schéma illustrant le principe connu de la réflectométrie temporelle et son application à la détection d'un défaut non franc,

[Fig. 2] la figure 2 représente un exemple de réflectogramme illustrant l'allure de la signature d'un défaut non franc,

[Fig. 3] la figure 3 représente un organigramme détaillant les étapes de réalisation d'une méthode de caractérisation selon l'invention,

[Fig. 4] la figure 4 représente un exemple de dispositif de caractérisation selon l'invention,

[Fig. 5] la figure 5 représente un exemple de réflectogramme fourni en entrée de la méthode selon l'invention,

[Fig. 6] la figure 6 représente un exemple de profil d'impédance caractéristique fourni en sortie de la méthode selon l'invention.

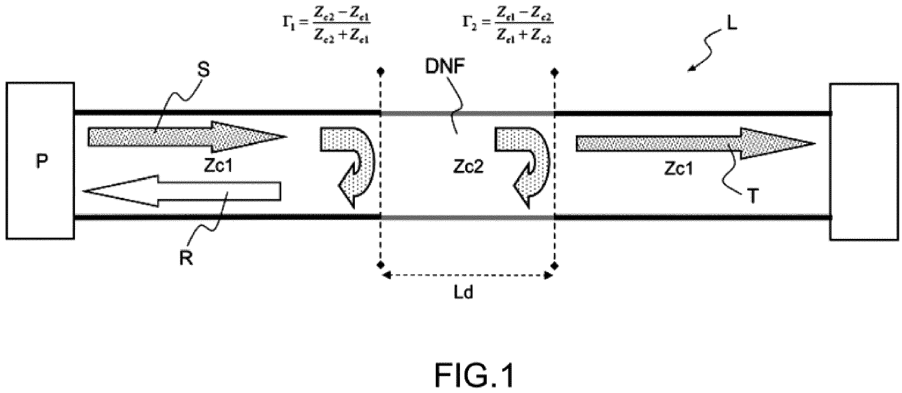

La figure 1 schématise, pour rappel, le principe de fonctionnement d'une méthode de diagnostic par réflectométrie appliquée à une ligne de transmission L présentant un défaut DNF, par exemple un défaut non franc. L'exemple décrit ci-dessous correspond à une méthode de réflectométrie temporelle.

Un signal de référence S, nommé également signal incident, est injecté dans la ligne de transmission en un point P. Le signal réfléchi R est mesuré au même point P (ou en un autre point de la ligne). Ce signal se propage dans la ligne et rencontre, au cours de sa propagation, une première discontinuité d'impédance à l'entrée du défaut DNF. Le signal se réfléchit sur cette discontinuité avec un coefficient de réflexion $\Gamma_1$. Si l'impédance caractéristique $Z_{c2}$ dans la zone du défaut non franc DNF est inférieure à l'impédance caractéristique $Z_{c1}$ avant l'apparition du défaut, alors le coefficient de réflexion $\Gamma_1$ est négatif et se traduit par un pic d'amplitude négative dans le signal réfléchi R. Dans le cas inverse, le coefficient de réflexion $\Gamma_1$ est positif et se traduit par un pic d'amplitude positive dans le signal réfléchi R.

La partie transmise du signal incident S continue de se propager dans la ligne au-delà du défaut (partie T sur la figure 1) et rencontre ensuite une deuxième discontinuité d'impédance créant une deuxième réflexion du signal incident avec un coefficient de réflexion $\Gamma_2$ de signe opposé au premier coefficient de réflexion $\Gamma_1$. Si $\Gamma_1$ < a alors $\Gamma_2$ > 0. Si $\Gamma_1$ > a alors $\Gamma_2$ < 0.

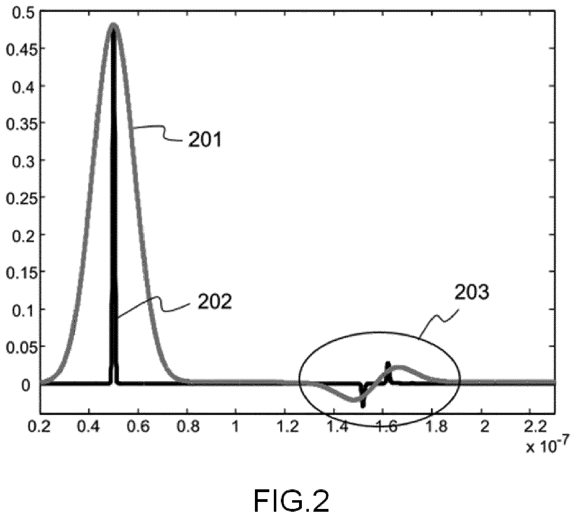

Ainsi, en observant le signal réfléchi R, la signature du défaut non franc DNF est caractérisée par deux pics successifs de signes inversés comme le montre la figure 2.

La figure 2 représente un réflectogramme temporel qui correspond soit directement à la mesure du signal réfléchi R, soit à l'intercorrélation entre le signal réfléchi R et le signal injecté dans le câble S.

Dans le cas où le signal de référence injecté est une impulsion temporelle, ce qui correspond au cas d'une méthode de réflectométrie temporelle, le réflectogramme peut correspondre directement à la mesure du signal réfléchi R. Dans le cas où le signal de référence injecté est un signal plus complexe, par exemple pour des méthodes de type MCTDR (Multi Carrier Time Domain Reflectometry) ou OMTDR (Orthogonal Multi tone Time Domain Reflectometry), alors le réflectogramme est obtenu en inter-corrélant le signal réfléchi R et le signal injecté S.

Sur la figure 2, on a représenté deux réflectogrammes 201,202 correspondants à deux durées d'impulsion différentes pour le signal injecté dans le câble ou autrement dit à deux fréquences différentes. La courbe 201 correspond à une durée d'impulsion 2.ΔT très supérieure au temps de traversée, par le signal, du défaut non franc DNF. La longueur du défaut étant notée Ld, cette durée vaut Ld/V, avec V la vitesse de propagation du signal dans le câble. La courbe 202 correspond à une durée d'impulsion 2.ΔT très inférieure au temps de traversée, par le signal, du défaut non franc DNF.

Dans les deux cas, la signature 203 du défaut non franc, dans le réflectogramme, est toujours composée de la succession d'un premier pic et d'un second pic dont les signes sont inversés.

La distance entre les deux pics représente la longueur du défaut non franc et leur amplitude représente la sévérité du défaut non franc. En effet, plus la variation de l'impédance caractéristique est importante, plus l'amplitude de la signature du défaut non franc dans le réflectogramme est également importante.

Plus la fréquence du signal est élevée plus la précision sur l'estimation de la longueur du défaut est importante comme cela peut être identifié sur la figure 2.

Comme cela est connu dans le domaine des méthodes de diagnostic par réflectométrie, la position $d_{DNF}$ du défaut non franc sur le câble, autrement dit sa distance au point P d'injection du signal, peut être directement obtenue à partir de la mesure, sur le réflectogramme temporel de la figure 2, de la durée $t_{DNF}$ entre le premier pic d'amplitude relevé sur le réflectogramme (à l'abscisse 0,5 sur l'exemple de la figure 2) et le pic d'amplitude 203 correspondant à la signature du défaut non franc.

Différentes méthodes connues sont envisageables pour déterminer la position $d_{DNF}$. Une première méthode consiste à appliquer la relation liant distance et temps : $d_{DNF} = V.t_{DNF}/2$ où V est la vitesse de propagation du signal dans le câble. Une autre méthode possible consiste à appliquer une relation de proportionnalité du type $d_{DNF}/t_{DNF} = L/t_0$ où L est la longueur du câble et $t_0$ est la durée, mesurée sur le réflectogramme, entre le pic d'amplitude correspondant à la discontinuité d'impédance au point d'injection et le pic d'amplitude correspondant à la réflexion du signal sur l'extrémité du câble.

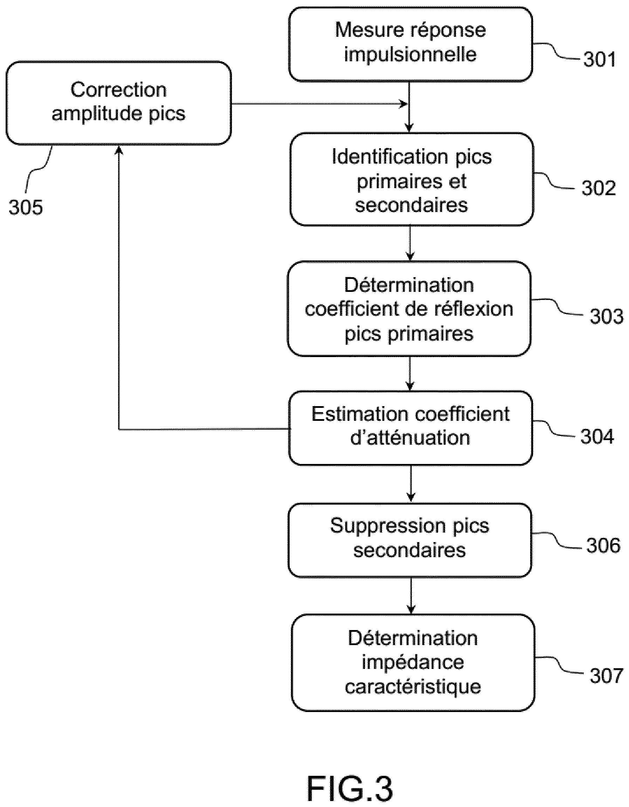

La figure 3 détaille les étapes de mise en oeuvre d'une méthode de caractérisation d'une ligne de transmission selon un mode de réalisation de l'invention.

La première étape 301 de la méthode consiste à acquérir, au moyen d'un équipement de mesure, une mesure de la réponse impulsionnelle du signal injecté dans le câble et rétropropagé au point de mesure.

Par exemple, cette étape consiste à injecter un signal de référence, par exemple un signal impulsionnel, en un point d'injection du câble (par exemple une extrémité du câble), puis à mesurer l'écho de ce signal réfléchi sur les discontinuités d'impédance du câble et rétropropagé jusqu'à un point de mesure qui peut être identique ou différent du point d'injection.

En pratique, un équipement de mesure fourni généralement un réflectogramme temporel à partir duquel on extrait la réponse impulsionnelle en décorrélant le réflectogramme du signal de référence.

Dans une variante de réalisation, en particulier lorsque le signal de référence est plus complexe qu'une simple impulsion, par exemple dans le cas d'un signal multi-porteuses, l'étape 301 comprend également une convolution ou corrélation de la mesure du signal rétro-propagé avec une copie du signal de référence injecté dans le câble. Dans ce cas, on obtient un réflectogramme temporel duquel il faut extraire la réponse impulsionnelle.

Dans une autre variante de réalisation de l'invention, une approche de type fréquentielle (Frequency Domain Reflectometry) est utilisée par le biais d'un signal occupant une certaine bande de fréquence. Dans ce cas, il est nécessaire d'appliquer une transformée en fréquence en réception pour obtenir une mesure de la réponse impulsionnelle. Il peut s'agir, par exemple, d'une transformée de Fourier ou d'une transformée de type chirp-Z inverse.

Afin d'obtenir une réponse impulsionnelle approximée, la mesure temporelle du signal réfléchi peut être analysée afin de détecter les extrema (maximum et minimum) des pics d'amplitude dans cette mesure. Ce faisant, on obtient une réponse impulsionnelle du câble.

Dans une autre variante de réalisation, une étape de filtrage du bruit de mesure est réalisée après acquisition de la mesure. Le filtrage du bruit est, par exemple, réalisé au moyen d'un seuil de valeur prédéterminée en fonction d'un rapport signal à bruit souhaité. Les valeurs de la réponse impulsionnelle sont comparées à ce seuil et seules les valeurs qui dépassent le seuil sont conservées, les autres valeurs étant mises à zéro.

L'étape de filtrage du bruit peut aussi être réalisée au moyen d'une déconvolution qui a pour but de retirer, de la mesure, la contribution du signal injecté afin d'obtenir une séquence comportant un ensemble de pics d'amplitude qui correspondent à la réponse du canal de propagation dans lequel se propage le signal. Chaque pic est identifié par sa position temporelle et son amplitude.

L'étape de déconvolution peut, par exemple, être réalisée par un algorithme de déconvolution connu comme l'algorithme CLEAN ou tout autre algorithme équivalent.

Selon une variante de réalisation de l'invention, l'algorithme de déconvolution peut être couplé à une étape supplémentaire d'interpolation linéaire afin d'améliorer la précision du positionnement temporel des pics qui est limitée par la résolution d'échantillonnage de l'appareil de mesure.

En sortie de l'étape 301, on obtient une valeur estimée de la réponse impulsionnelle du câble au signal de référence. Cette réponse est constituée d'une séquence de pics qui offre une première représentation de la désadaptation d'impédance le long du câble.

A l'étape suivante 302, on recherche, pour chaque pic d'amplitude de la séquence obtenue à l'étape 301 si ce pic correspond à une réflexion primaire ou à une réflexion secondaire du signal sur une désadaptation d'impédance.

L'invention est basée sur une modélisation de la désadaptation équivalente du câble à analyser en une succession de tronçons d'impédance caractéristique et de longueur propre.

En partant de cette modélisation, il est possible de représenter la fonction de transfert H(f) d'une ligne de transmission en fonction de la fréquence par la formule suivante :

$$H(f) = \rho_1 + \sum_{i=2}^{N} \prod_{j=1}^{i-1} (1 - \rho_j^2) \rho_i . e^{-2*j*\pi*f*t_j} + X_{rebonds} \qquad (1)$$

Selon la relation (1), le nombre de tronçons d'impédances caractéristiques distinctes est égal à N+1. N est donc le nombre d'interfaces entre deux tronçons sur lesquels le signal peut se réfléchir, hors interface avec l'équipement de mesure et fin de câble. $t_i$ est la durée correspondant au $i^{ème}$ tronçon. $\rho_i$ est la partie réelle du coefficient de réflexion du signal sur l'interface entre le $i^{ème}$ tronçon et le $(i+1)^{ème}$ tronçon. $X_{rebonds}$ est un terme qui dépend des rebonds multiples du signal sur les différentes interfaces.

Le signal s(t) réfléchi mesuré par réflectométrie est modélisé par la relation s(t)= $S_i(t)$ * $R_{imp}(t)$ où $S_i$ est le signal d'injection et $R_{imp}$ est la réponse impulsionnelle du câble qui est égale à la transformée de Fourrier inverse de la fonction de transfert H(f).

Pour caractériser une désadaptation modélisée à l'aide de la relation (1), cela revient à trouver les valeurs des parties réelles des coefficients de réflexions $\rho_i$ et des durées $t_i$ correspondant à chaque tronçon.

Ainsi, la désadaptation d'impédance équivalente du câble peut être modélisée par une succession de tronçons ayant chacun une impédance caractéristique constante sur la longueur du tronçon, deux tronçons consécutifs étant séparés par une interface correspondant à une rupture ou une discontinuité d'impédance sur laquelle une partie du signal injecté peut se réfléchir.

L'amplitude $A_i$ de chaque pic est reliée à la valeur de la partie réelle du coefficient de réflexion $\rho_i$ du signal sur l'interface d'indice temporel i qui correspond au $i^{ème}$ pic de la séquence et aux valeurs des parties réelles des coefficients de réflexion $\rho_j$ des interfaces correspondantes aux pics antérieurs au $i^{ème}$ pic, par la relation suivante :

$$\rho_{1=}A_1$$

$$\forall i \in [2,N], \rho_i = \frac{A_i}{\prod_{j=1}^{i-1}\left(1-\left(\rho_j\right)^2\right)} \qquad (2)$$

La séquence de pics obtenue en sortie de l'étape 301 donne donc une première approximation de la désadaptation équivalente selon la modélisation précitée. Cette modélisation est valable uniquement pour les pics primaires et ne prend pas en compte l'atténuation du signal. Par ailleurs, l'amplitude $A_i$ de chaque pic est également constituée, en tout ou partie, des contributions des réflexions ou rebonds secondaires du signal sur les interfaces. On parle de rebond secondaire du signal pour désigner les réflexions multiples du signal sur une interface, c'est-à-dire des réflexions intervenant après la première réflexion.

L'étape 302 de la méthode consiste donc à identifier, pour chaque pic de la réponse impulsionnelle, s'il s'agit d'une réflexion primaire ou secondaire. Par la suite, on appellera « pic primaire » un pic associé à une réflexion primaire du signal sur une interface et « pic secondaire » un pic associé à une réflexion secondaire du signal sur une interface.

Selon un mode de réalisation particulier de l'invention, l'étape 302 peut être réalisée au moyen des sous-étapes suivantes.

Premièrement, il s'agit d'identifier les pics situés à une position temporelle de la réponse impulsionnelle qui correspond potentiellement à un écho issu d'une réflexion multiple du signal sur une interface. Ensuite, pour ces pics identifiés, on calcule la contribution en amplitude d'une réflexion multiple, puis on compare cette contribution à l'amplitude dudit pic identifié. Si la différence entre les deux amplitudes est sensiblement nulle, cela signifie que ce pic correspond intégralement à une réflexion secondaire du signal dans le cas contraire, il peut s'agir de la superposition d'une réflexion primaire et d'une réflexion secondaire.

Plus précisément, l'étape 302 du procédé selon l'invention peut être réalisée à l'aide de l'algorithme suivant.

Dans une première itération du procédé, on sélectionne les deux premiers pics de la réponse impulsionnelle. On sait que ces deux premiers pics correspondent à des interfaces sur lesquelles aucun rebond multiple du signal n'est intervenu.

L'espacement temporel entre ces deux pics est mesuré, puis, on recherche, dans la séquence, les pics situés à des positions temporelles multiples de la distance temporelle entre les deux premiers pics. Autrement dit, si on note dt la distance temporelle entre les deux premiers pics sélectionnés, on recherche les pics situés à des distances n * dt du premier pic, où n est un entier positif. En effet, on sait que les réflexions secondaires apparaissent uniquement à ces positions. La distance réelle d entre deux interfaces est liée à la distance temporelle dt par la relation d=v.dt/2 où v est la vitesse de propagation du signal dans le câble.

A partir de la relation (2) et des amplitudes des deux premiers pics sélectionnés, on peut calculer les parties réelles des coefficients de réflexion $\rho_1$ et $\rho_2$ associés aux interfaces correspondantes à ces deux premiers pics. Ensuite, la relation suivante (3) permet de déterminer l'amplitude du $n^{ème}$ rebond de signal sur l'interface i :

$$| \forall i \in [1:N], \forall j \in [1:N], \forall n \in \mathbb{R}, R_{n,i,j} = (-1)^n \rho_i^n * \rho_j^{n+1} * \prod_{k=1}^{i} \tau_k \qquad (3)$$

$\rho_i$ est la partie réelle du coefficient de réflexion sur l'interface i

$\rho_j$ est la partie réelle du coefficient de réflexion sur l'interface j

$R_{n,i,j}$ est l'amplitude du $n^{ième}$ rebond entre l'interface i et j

$\tau_k$ est la partie réelle du coefficient de transmission sur l'interface k

La valeur $R_{n,i,j}$ de l'amplitude du $n^{ième}$ rebond est ensuite comparée aux amplitudes des pics détectés aux positions temporelles ndt. Autrement dit, pour une valeur de n donnée pour laquelle un pic a été détecté à la position ndt, on compare son amplitude à la valeur $R_{n,i,j}$. Si ces deux valeurs sont sensiblement identiques, cela signifie que le pic détecté à la position ndt est un pic secondaire sinon il peut s'agit de la superposition d'un pic primaire et d'un pic secondaire.

Lors de l'itération initiale du procédé, une valeur a priori de l'atténuation peut être fixée et prise en compte pour compenser les valeurs $R_{n,i,j}$.

Le paramètre n égal au nombre de rebonds secondaires du signal sur une interface est un paramètre réglable du procédé.

Le processus décrit ci-dessus peut être réitéré pour l'ensemble des pics de la séquence en modifiant à chaque fois les deux premiers pics sélectionnés pour lesquels la valeur $R_{n,i,j}$ de l'amplitude du nième rebond est calculée.

Plus précisément, à chaque itération, on sélectionne les couples de pics suivants, identifiés par leur numéro d'ordre d'apparition : {1 ;2}, {1 ;3}, {2 ;3}, {1 ;4}, {2 ;4}, {3 ;4} et ainsi de suite. Autrement dit, à chaque nouvelle itération on sélectionne comme deuxième pic le pic successif aux deux pics sélectionnés à l'itération précédente et comme premier pic, l'un des pics sélectionnés à l'une des itérations précédentes en faisant varier le premier pic sur tous les pics sélectionnés aux itérations précédentes.

Conjointement, dans une étape 303, on détermine une valeur estimée des coefficients de réflexion (ou plus précisément des parties réelles de ces coefficients de réflexion) des pics identifiés comme étant des pics primaires à l'aide des relations (2) et (3).

A l'issue de l'étape 303, on obtient deux vecteurs, le premier correspondant aux pics identifiés comme « primaires » et le second correspondant aux pics identifiés comme « secondaires ». Au cours de l'étape 303, les amplitudes $A_i$ des pics qui correspondent à une superposition de pics primaires et secondaires sont corrigés de la valeur $R_{n,i,j}$ calculée ci-dessus pour ne conserver que la contribution du pic primaire qui est classé dans le vecteur des pics primaires. Le coefficient de réflexion est ensuite calculé à l'aide de la relation (2) à partir de l'amplitude $A_i$ corrigée.

Ce premier résultat n'est qu'une approximation car l'atténuation du signal le long du câble n'a pas été prise en compte dans ce calcul.

C'est pourquoi, dans une étape 304 on détermine une première valeur estimée du coefficient d'affaiblissement ou coefficient d'atténuation du signal se propageant dans le câble.

Pour cela, on applique une loi définie par la relation (4) suivante :

$$s * \prod_i (1 - \rho(i)^2) * e^{-\sum_i a_i d_i} = A_f \ (4)$$

avec $a_i$ un coefficient d'atténuation sur un tronçon du câble situé après l'interface i, $A_f$ l'amplitude du pic associé à la terminaison de la ligne de transmission, $d_i$ la position d'un pic primaire i dans la réponse impulsionnelle, $\rho(i)$ la partie réelle du coefficient de réflexion associé au pic primaire i et s une fonction signe égale à -1 ou 1 selon la nature de la terminaison de la ligne de transmission (court-circuit ou circuit ouvert).

En considérant, un coefficient d'atténuation moyen a, l'équation (4) se simplifie en :

$$s * \prod_i (1 - \rho(i)^2) * e^{-a \sum_i d_i} = A_f \ (5)$$

Les valeurs $\rho(i)$, $d_i$ et $A_f$ sont déterminées à partir de la réponse impulsionnelle ou à l'issue des étapes 302 et 303. La somme des distances $d_i$ est égale à la longueur totale du câble qui est une information connue.

On en déduit ainsi une valeur estimée du coefficient d'atténuation moyen a.

**EP 4 001 934 B1**

L'étape 304 est réalisée sans besoin de connaissances a priori sur les caractéristiques physiques du câble et en exploitant directement la réponse impulsionnelle déterminée aux étapes 302 et 303. Par ailleurs, elle ne nécessite pas, contrairement à certaines méthodes de l'art antérieur, de calcul dans le domaine fréquentiel.

Ensuite, dans une étape 305, le coefficient d'atténuation moyen a est utilisé pour corriger l'amplitude de tous les pics de la réponse impulsionnelle, en multipliant chaque pic par le coefficient $e^{2ad_i}$, où $d_i = v.dt_i/2$ et $dt_i$ est la distance temporelle entre le début de la réponse impulsionnelle et le pic d'indice i, mesurée sur la réponse impulsionnelle.

On obtient alors une réponse impulsionnelle corrigée de l'effet de l'atténuation du signal. Cette nouvelle réponse impulsionnelle est utilisée pour appliquer à nouveau les étapes 302 et 303 décrites précédemment.

Plusieurs itérations des étapes 302,303,304,305 sont réalisées jusqu'à atteindre une convergence définie par un critère de convergence. Par exemple le critère de convergence correspond à un nombre d'itérations prédéterminé ou bien il peut consister à évaluer la variation de l'estimation a et à stopper les itérations lorsque cette variation passe en dessous d'un certain seuil.

Dans une autre variante de réalisation, les boucles d'itération sont réalisées uniquement sur les étapes 303,304,305, l'étape 302 d'identification des pics primaires étant réalisées seulement à l'étape initiale.

Ensuite, dans une étape 306, les pics secondaires sont supprimés de la réponse impulsionnelle et on corrige la valeur des pics correspondant à la superposition d'un pic primaire et d'un pic secondaire de la valeur $R_{n,i,j}$ calculée à l'étape 302.

On obtient en sortie de l'étape 306 une réponse impulsionnelle comprenant uniquement les pics primaires avec leurs coefficients de réflexion associés.

Enfin, dans une étape 307, on calcule une impédance caractéristique associée à chaque pic primaire, au moyen de la relation suivante :

Zc (i+1)= Zc (i * ((1+ρ(i)))/((1-ρ(i))) avec l'impédance du générateur Zc(0) connue, où Zc (i) est l'impédance du $i^{ème}$ tronçon et ρ(i) le coefficient de réflexion dû à ce $i^{ème}$ tronçon.

Dans une variante de réalisation, un profil continu de variation de l'impédance caractéristique est en outre déterminé à partir des valeurs discrètes de Zc(i) et d'une modélisation de Ricatti tel que décrit dans la référence [3].

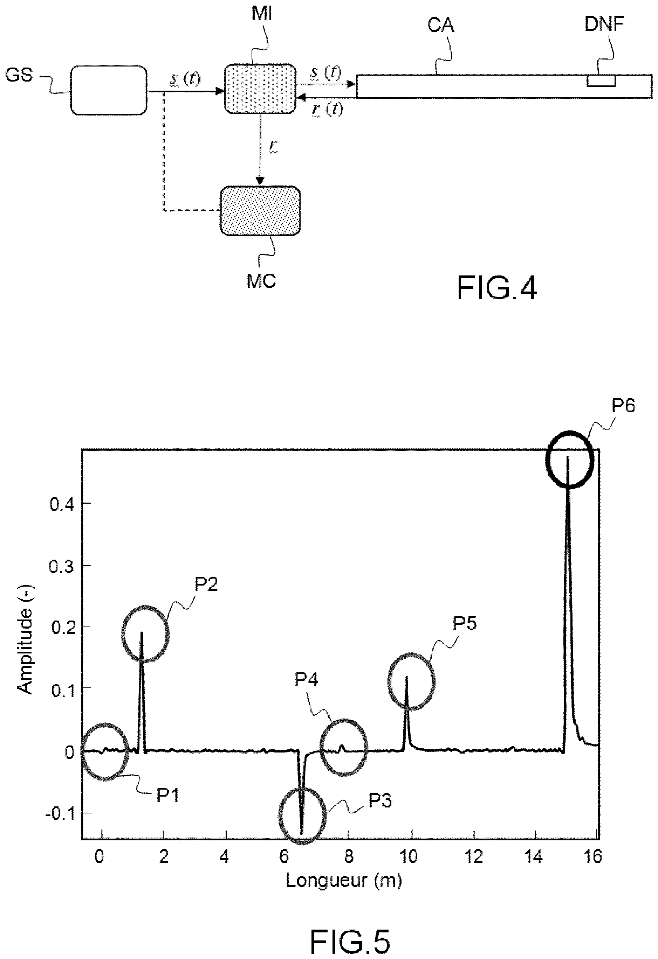

La figure 4 schématise, sur un synoptique, un exemple de dispositif de réflectométrie apte à mettre en oeuvre le procédé selon l'invention.

Un dispositif de réflectométrie, ou réflectomètre, comporte au moins un générateur de signal GS, pour générer un signal de test s et l'injecter dans le câble à analyser CA qui comporte, par exemple, un défaut DNF, un équipement de mesure MI pour mesurer le signal réfléchi r dans le câble CA et un composant électronique MC de type circuit intégré, tel un circuit à logique programmable, par exemple de type FPGA ou un micro-contrôleur, par exemple un processeur de signal numérique, qui reçoit une mesure du signal réfléchi r(t) et est configuré pour exécuter le procédé selon l'invention afin de caractériser l'impédance caractéristique de la ligne de transmission. Le composant électronique MC peut également comporter à la fois un circuit intégré, par exemple pour réaliser l'acquisition du signal réfléchi, et un micro-contrôleur pour exécuter les étapes de traitement requises par l'invention.

L'injection du signal de test s dans le câble est, par exemple, réalisée par un dispositif de couplage (non représenté à la figure 4) qui peut être un coupleur à effet capacitif ou inductif ou encore à l'aide d'une connexion ohmique. Le dispositif de couplage peut être réalisé par des connecteurs physiques qui relient le générateur de signal au câble ou par des moyens sans contact, par exemple en utilisant un cylindre métallique dont le diamètre interne est sensiblement égal au diamètre externe du câble et qui produit un effet de couplage capacitif avec le câble.

L'acquisition du signal réfléchi dans le câble peut également être réalisée au moyen d'un dispositif de couplage du type décrit précédemment.

Le dispositif de réflectométrie peut également comporter un convertisseur numérique-analogique disposé entre le générateur de signal de test, dans le cas où il s'agit d'un signal numérique, et le coupleur d'injection.

Le dispositif de réflectométrie peut également comporter un convertisseur analogique-numérique disposé entre le coupleur de mesure du signal réfléchi et l'équipement de mesure MI ou le composant électronique MC aux fins de numériser le signal analogique mesuré.

En outre, une unité de traitement (non représentée à la figure 4), de type ordinateur, assistant numérique personnel ou autre est utilisée pour piloter le système de réflectométrie selon l'invention et afficher les résultats des mesures sur une interface homme-machine.

Les résultats affichés peuvent comprendre la réponse impulsionnelle calculée à l'aide du procédé selon l'invention et/ou une information relative à l'existence et à la localisation d'un défaut sur le câble également produite par le procédé selon l'invention. Les résultats affichés peuvent aussi comprendre un profil d'impédance caractéristique associé au câble CA, c'est-à-dire représentant, pour une pluralité de points du câble CA, la valeur correspondante de son impédance caractéristique.

Selon un mode de réalisation particulier, le signal de test s injecté peut également être fourni au composant MC lorsque les traitements réalisés nécessitent la connaissance du signal injecté, notamment lorsque ceux-ci incluent une étape d'intercorrélation entre le signal de test s et le signal réfléchi r.

7

L'injection du signal dans le câble et la mesure du signal réfléchi sont, par exemple, réalisées par un seul et même composant mais aussi par deux composants distincts, notamment lorsque le point d'injection et le point de mesure sont dissociés.

Le dispositif décrit à la figure 4 est, par exemple, mis en oeuvre par une carte électronique sur laquelle sont disposés les différents composants. La carte peut être connectée au câble par un coupleur.

La figure 5 représente un exemple de réflectogramme temporel utilisé en entrée de l'étape 301 de la méthode selon l'invention A partir de ce réflectogramme, on extrait une réponse impulsionnelle par déconvolution avec le signal de référence. Ce réflectogramme comporte plusieurs pics P1,P2,P3,P4,P5 dont un pic de fin de câble P6.

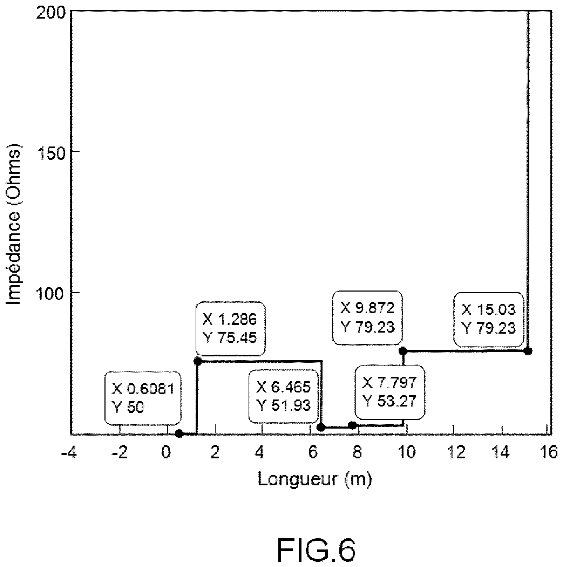

La figure 6 illustre le profil d'impédance caractéristique obtenu à l'issue de l'étape 307 de la méthode selon l'invention pour le réflectogramme de la figure 5 dont la réponse impulsionnelle est extraite. Les valeurs X correspondent à la position de la désadaptation d'impédance sur le câble et les valeurs Y correspondent aux valeurs de l'impédance caractéristique.

Le profil d'impédance caractéristique permet de caractériser la présence de défauts sur le câble, un défaut étant associé à une valeur d'impédance caractéristique différente de l'impédance du câble. Il peut également être utilisé plus généralement pour caractériser toute discontinuité d'impédance, notamment liée à la présence de connecteurs, d'appareils de mesures ou de charges de natures diverses.

Références

[1] Inverse Scattering Experiments for electric cable soft fault diagnosis and connector location. Piers Online, pages 1932-1936. Loete, F., Zhang, Q. et Sorine, M. (2012*).*

[2] Experimental Validation of the Inverse Scattering Method for Distributed Characteristic Impédance Estimation. IEEE Transactions on Antennas and Propagation, 63(6):2532-2538. Loete, F., Zhang, Q. et Sorine, M. (2015*).*

[3] Développement d'une nouvelle méthode de détermination des profils de teneur en eau dans les sols par inversion d'un signal TDR, Luiz Antonio Pereira Dos Santos, thèse de l'université Joseph Fourier, Grenoble I.

**Revendications**

1. Méthode de caractérisation d'une ligne de transmission comprenant les étapes successives de :

   a) Réaliser (301) une mesure de la réponse impulsionnelle temporelle d'un signal de référence propagé dans la ligne à partir d'un point d'injection puis rétro-propagé en un point de mesure, la mesure temporelle comprenant une pluralité de pics d'amplitude correspondant chacun à une discontinuité d'impédance,
   b) Identifier (302), pour chaque pic d'amplitude, s'il correspond à une réflexion primaire ou secondaire du signal sur une discontinuité d'impédance,
   c) Déterminer (303), à partir de l'amplitude des pics primaires, une valeur estimée du coefficient de réflexion associé aux discontinuités d'impédances correspondantes,
   d) Estimer (304) un coefficient d'atténuation moyen le long de la ligne au moyen de la relation suivante $s * \Pi_i(1 - \rho(i)^2) * e^{-a\Sigma_i d_i} = A_f$ , avec a le coefficient d'atténuation moyen, Af l'amplitude d'un pic associé à la terminaison de la ligne de transmission, di la position d'un pic primaire i dans la réponse impulsionnelle, $\rho(i)$ la partie réelle du coefficient de réflexion associé au pic primaire i et s une fonction signe égale à 1 ou -1 selon la nature de la terminaison de la ligne de transmission, pour i variant de 2 à N, avec N le nombre d'interfaces entre deux tronçons sur lesquels le signal peut se réfléchir, hors interface avec l'équipement de mesure et fin de câble.
   e) Corriger (305) les amplitudes des pics de la réponse impulsionnelle à partir du coefficient d'atténuation moyen et reboucler à l'étape b) ou à l'étape c),
   f) Déterminer (307) une impédance caractéristique associée à chaque pic primaire à partir de chaque coefficient de réflexion.

2. Méthode de caractérisation d'une ligne de transmission selon la revendication 1 dans laquelle les étapes b),c),d) et e) ou c),d),et e) sont itérées plusieurs fois jusqu'à vérifier un critère de convergence prédéterminé.

3. Méthode de caractérisation d'une ligne de transmission selon l'une quelconque des revendications précédentes dans laquelle l'étape b) comprend les sous étapes de :

- Sélectionner, dans la réponse impulsionnelle, un premier pic et un deuxième pic et mesurer leur espacement temporel dt,
- Rechercher au moins un troisième pic distant du premier pic d'un espacement temporel ndt multiple de l'espacement temporel dt entre le premier pic et le deuxième pic,
- Déterminer une valeur estimée des coefficients de réflexion associés aux discontinuités d'impédance correspondant respectivement au premier et au deuxième pic, à partir des amplitudes du premier et du deuxième pic,
- Déterminer une valeur estimée de l'amplitude du $n^{ième}$ rebond du signal sur la discontinuité d'impédance correspondant au deuxième pic, n variant sur les valeurs correspondantes aux multiples ndt de l'espacement temporel dt auxquels a été trouvé un troisième pic,
- Comparer cette valeur estimée à l'amplitude de l'au moins un troisième pic, et si la valeur estimée est sensiblement égale à l'amplitude du pic, en déduire que le pic situé à une distance temporelle ndt est un pic secondaire, sinon en déduire que c'est un pic primaire.

4. Méthode de caractérisation d'une ligne de transmission selon la revendication 3 dans laquelle lesdites sous-étapes sont itérées et,

   • à la première itération, le premier pic sélectionné est le premier pic dans l'ordre temporel d'apparition, le deuxième pic sélectionné est le deuxième pic dans l'ordre temporel d'apparition,
   • et aux itérations suivantes, le deuxième pic sélectionné est le pic successif aux deux pics sélectionnés à l'itération précédente et le premier pic sélectionné est l'un des pics sélectionnés à l'une des itérations précédentes.

5. Méthode de caractérisation d'une ligne de transmission selon l'une des revendications précédentes dans laquelle la valeur estimée (303) du coefficient de réflexion associé à chaque discontinuité d'impédance est déterminée à l'aide de la relation suivante :

$$\rho_{1=}A_1$$

$$\rho_i = \frac{A_i}{\prod_{j=1}^{i-1}\left(1-\left(\rho_j\right)^2\right)}$$

pour i variant de 2 à N, avec $A_i$ l'amplitude d'un pic indicé temporellement par l'entier i, $\rho_i$ le coefficient de réflexion d'une onde réfléchie sur la discontinuité d'impédance associée audit pic, $\rho_j$ les coefficients de réflexion d'une onde réfléchie sur les discontinuités d'impédance associées aux pics précédents ledit pic.

6. Méthode de caractérisation d'une ligne de transmission selon l'une quelconque des revendications précédentes comprenant en outre une étape de filtrage de la réponse impulsionnelle au moyen d'une comparaison de chaque pic à un seuil prédéterminé.

7. Méthode de caractérisation d'une ligne de transmission selon l'une quelconque des revendications précédentes comprenant en outre une étape de déconvolution appliquée à la réponse impulsionnelle.

8. Méthode de caractérisation d'une ligne de transmission selon l'une quelconque des revendications précédentes comprenant en outre une étape de caractérisation d'un défaut associé à au moins une discontinuité d'impédance à partir de son impédance caractéristique.

9. Méthode de caractérisation d'une ligne de transmission selon l'une quelconque des revendications précédentes comprenant en outre une étape de détermination d'une variation continue d'impédance caractéristique le long de la ligne de transmission, à partir des impédances caractéristiques déterminées et d'un modèle.

10. Programme d'ordinateur comportant des instructions qui conduisent le système selon la revendication 12 à l'exécution de la méthode de caractérisation d'une ligne de transmission selon l'une quelconque des revendications Z précédentes.

11. Support d'enregistrement lisible par un processeur sur lequel est enregistré le programme d'ordinateur selon la revendication 10.

12. Système de caractérisation d'une ligne de transmission comprenant un générateur de signal de référence (GS) configuré pour injecter un signal de référence dans une ligne de transmission (CA) en un point d'injection, un équipement de mesure (MI) configuré pour mesurer le signal rétro-propagé en un point de mesure et une unité de traitement (MC) ; le système étant configuré pour exécuter les étapes de la méthode selon l'une quelconque des revendications 1 à 9.

**Patentansprüche**

1. Verfahren zum Charakterisieren einer Übertragungsleitung, das die folgenden aufeinanderfolgenden Schritte umfasst:

a) Durchführen (301) einer Messung der zeitlichen Impulsantwort eines Referenzsignals, das in der Leitung von einem Einspeisepunkt aus verbreitet und dann an einem Messpunkt rückwärts verbreitet wird, wobei die zeitliche Messung eine Vielzahl von Amplitudenspitzen umfasst, die jeweils einer Impedanzdiskontinuität entsprechen,

b) Identifizieren (302), für jede Amplitudenspitze, ob sie einer primären oder sekundären Reflexion des Signals auf einer Impedanzdiskontinuität entspricht,

c) Bestimmen (303), auf der Basis der Amplitude der primären Spitzen, eines Schätzwerts des mit den entsprechenden Impedanzdiskontinuitäten assoziierten Reflexionskoeffizienten,

d) Schätzen (304) eines mittleren Dämpfungskoeffizienten entlang der Leitung anhand der folgenden Beziehung $s * \Pi_i(1 - \rho(i)^2) * e^{-a\Sigma_i d_i} = A_f$, wobei a der mittlere Dämpfungskoeffizient ist, $A_f$ die Amplitude einer mit dem Abschluss der Übertragungsleitung assoziierten Spitze ist, $d_i$ die Position einer primären Spitze i in der Im-pulsantwort ist, $\rho(i)$ der Realteil des mit der primären Spitze i assoziierten Reflexionskoeffizienten ist und s eine Vorzeichenfunktion gleich 1 oder -1 je nach Art des Abschlusses der Übertragungsleitung ist, wobei i von 2 bis N variiert, wobei N die Anzahl von Schnittstellen zwischen zwei Abschnitten ist, auf denen das Signal reflektiert werden kann, außerhalb einer Schnittstelle mit der Messausrüstung und dem Kabelende,

e) Korrigieren (305) der Spitzenamplituden der Impulsantwort auf der Basis des mittleren Dämpfungskoeffizienten und Zurückgehen zu Schritt b) oder zu Schritt c),

f) Bestimmen (307) einer mit jeder primären Spitze assoziierten charakteristischen Impedanz auf der Basis von jedem Reflexionskoeffizienten.

2. Verfahren zum Charakterisieren einer Übertragungsleitung nach Anspruch 1, wobei die Schritte b), c), d) und e) oder c), d) und e) mehrfach iteriert werden, bis ein vorbestimmtes Konvergenzkriterium verifiziert ist.

3. Verfahren zum Charakterisieren einer Übertragungsleitung nach einem der vorhergehenden Ansprüche, wobei Schritt b) die folgenden Unterschritte umfasst:

- Auswählen, aus der Impulsantwort, einer ersten Spitze und einer zweiten Spitze und Messen ihres zeitlichen Abstands dt,

- Suchen nach mindestens einer dritten Spitze, die von der ersten Spitze um einen zeitlichen Abstand ndt entfernt ist, der ein Vielfaches des zeitlichen Abstands dt zwischen der ersten Spitze und der zweiten Spitze beträgt,

- Bestimmen eines Schätzwerts der mit den Impedanzdiskontinuitäten assoziierten Reflexionskoeffizienten jeweils entsprechend der ersten und der zweiten Spitze auf der Basis der Amplituden der ersten und der zweiten Spitze,

- Bestimmen eines Schätzwerts der Amplitude des n-ten Signalrückpralls auf der Impedanzdiskontinuität entsprechend der zweiten Spitze, wobei n über die Werte variiert, die den Vielfachen ndt des zeitlichen Abstands dt entsprechen, an denen eine dritte Spitze gefunden wurde,

- Vergleichen dieses Schätzwerts mit der Amplitude der mindestens einen dritten Spitze, und wenn der Schätzwert im Wesentlichen gleich der Amplitude der Spitze ist, Schlussfolgern, dass die Spitze, die sich an einem zeitlichen Abstand ndt befindet, eine sekundäre Spitze ist, andernfalls Schlussfolgern, dass sie eine primäre Spitze ist.

4. Verfahren zum Charakterisieren einer Übertragungsleitung nach Anspruch 3, wobei die Unterschritte iteriert werden und,

• bei der ersten Iteration die erste ausgewählte Spitze die erste Spitze in der zeitlichen Reihenfolge des Auftretens ist, die zweite ausgewählte Spitze die zweite Spitze in der zeitlichen Reihenfolge des Auftretens ist,
• und bei den folgenden Iterationen die zweite ausgewählte Spitze die auf die beiden bei der vorherigen Iteration ausgewählten Spitzen folgende Spitze und die erste ausgewählte Spitze eine der bei einer der vorherigen Iterationen ausgewählten Spitzen ist.

5. Verfahren zum Charakterisieren einer Übertragungsleitung nach einem der vorhergehenden Ansprüche, wobei der Schätzwert (303) des mit jeder Impedanzdiskontinuität assoziierten Reflexionskoeffizienten mithilfe der folgenden Beziehung bestimmt wird:

$$\rho_{1=}A_1$$

$$\rho_i = \frac{A_i}{\prod_{j=1}^{i-1}\left(1-(\rho_j)^2\right)}$$

wobei i von 2 bis N variiert, wobei $A_i$ die Amplitude einer Spitze ist, die zeitlich durch die ganze Zahl i indiziert wird, $\rho_i$ der Reflexionskoeffizient einer Welle ist, die auf der mit der Spitze assoziierten Impedanzdiskontinuität reflektiert wird, $\rho_j$ die Reflexionskoeffizienten einer Welle sind, die auf den Impedanzdiskontinuitäten reflektiert wird, die mit den der Spitze vorhergehenden Spitzen assoziiert sind.

6. Verfahren zum Charakterisieren einer Übertragungsleitung nach einem der vorhergehenden Ansprüche, das ferner einen Schritt des Filterns der Impulsantwort anhand eines Vergleichs jeder Spitze mit einem vorbestimmten Schwellenwert umfasst.

7. Verfahren zum Charakterisieren einer Übertragungsleitung nach einem der vorhergehenden Ansprüche, das ferner einen auf die Impulsantwort angewendeten Entfaltungsschritt umfasst.

8. Verfahren zum Charakterisieren einer Übertragungsleitung nach einem der vorhergehenden Ansprüche, das ferner einen Schritt des Charakterisierens eines mit mindestens einer Impedanzdiskontinuität assoziierten Fehlers auf der Basis ihrer charakteristischen Impedanz umfasst.

9. Verfahren zum Charakterisieren einer Übertragungsleitung nach einem der vorhergehenden Ansprüche, das ferner einen Schritt des Bestimmens einer kontinuierlichen Änderung der charakteristischen Impedanz entlang der Übertragungsleitung auf der Basis der bestimmten charakteristischen Impedanzen und eines Modells umfasst.

10. Computerprogramm, das Befehle umfasst, die das System nach Anspruch 12 zur Ausführung des Verfahrens zum Charakterisieren einer Übertragungsleitung nach einem der vorhergehenden Ansprüche veranlassen.

11. Von einem Prozessor lesbares Speichermedium, auf dem das Computerprogramm nach Anspruch 10 gespeichert ist.

12. System zum Charakterisieren einer Übertragungsleitung, das Folgendes umfasst: einen Referenzsignalgenerator (GS), konfiguriert zum Einspeisen eines Referenzsignals an einem Einspeisepunkt in eine Übertragungsleitung (CA), eine Messausrüstung (MI), konfiguriert zum Messen des rückwärts verbreiteten Signals an einem Messpunkt, und eine Verarbeitungseinheit (MC); wobei das System dafür konfiguriert ist, die Schritte des Verfahrens nach einem der Ansprüche 1 bis 9 auszuführen.

**Claims**

1. A method for characterising a transmission line comprising the following successive steps of:

a) Taking (301) a measurement of the temporal impulse response of a reference signal propagated through the line from an injection point, then back-propagated at a measurement point, with the temporal measurement comprising a plurality of amplitude peaks each corresponding to an impedance discontinuity,
b) identifying (302), for each amplitude peak, whether it corresponds to a primary or secondary reflection of the signal on an impedance discontinuity;

c) determining (303), based on the amplitude of the primary peaks, an estimated value of the reflection coefficient associated with the corresponding impedance discontinuities;

d) estimating (304) an average attenuation coefficient along the line by means of the following relationship s * $\Pi_i(1 - \rho(i)^2) * e^{-a\Sigma_i d_i} = A_f$, with a being the average attenuation coefficient, Af being the amplitude of a peak associated with the end of the transmission line, di being the position of a primary peak i in the impulse response, $\rho$(i) being the real part of the reflection coefficient associated with the primary peak i, and s being a sign function equal to 1 or -1 depending on the nature of the end of the transmission line, for i varying from 2 to N, with N being the number of interfaces between two sections on which the signal can reflect, excluding an interface with the measurement equipment and the end of the cable,

e) correcting (305) the amplitudes of the peaks of the impulse response based on the average attenuation coefficient and returning to step b) or to step c);

f) determining (307) a characteristic impedance associated with each primary peak based on each reflection coefficient.

2. The method for characterising a transmission line according to claim 1, wherein steps b), c), d) and e) or c), d) and e) are iterated several times until a predetermined convergence criterion is verified.

3. The method for characterising a transmission line according to any one of the preceding claims, wherein step b) comprises the following sub-steps of:

- selecting, in the impulse response, a first peak and a second peak and measuring their temporal spacing dt,
- searching for at least one third peak distant from the first peak by a temporal spacing ndt that is a multiple of the temporal spacing dt between the first peak and the second peak,
- determining an estimated value of the reflection coefficients associated with the impedance discontinuities respectively corresponding to the first and to the second peak, based on the amplitudes of the first and of the second peak,
- determining an estimated value of the amplitude of the $n^{th}$ rebound of the signal on the impedance discontinuity corresponding to the second peak, with n varying over the values corresponding to the multiples ndt of the temporal spacing dt at which a third peak has been found,
- comparing this estimated value with the amplitude of the at least one third peak, and if the estimated value is substantially equal to the amplitude of the peak, deducing that the peak located at a temporal distance ndt is a secondary peak, otherwise deducing that it is a primary peak.

4. The method for characterising a transmission line according to claim 3, wherein said sub-steps are iterated and,

• during the first iteration, the first selected peak is the first peak in the temporal order of occurrence, the second selected peak is the second peak in the temporal order of occurrence,
• and during the following iterations, the second selected peak is the peak following the two peaks selected during the previous iteration and the first selected peak is one of the peaks selected during one of the previous iterations.

5. The method for characterising a transmission line according to any one of the preceding claims, wherein the estimated value (303) of the reflection coefficient associated with each impedance discontinuity is determined using the following relationship:

$$\rho_{1=}A_1$$

$$\rho_i = \frac{A_i}{\prod_{j=1}^{i-1}\left(1-(\rho_j)^2\right)}$$

for i varying from 2 to N, with $A_i$ being the amplitude of a peak temporally indexed by the integer i, $\rho_i$ being the reflection coefficient of a wave reflected on the impedance discontinuity associated with said peak, $\rho_j$ being the reflection coefficients of a wave reflected on the impedance discontinuities associated with the peaks preceding said peak.

6. The method for characterising a transmission line according to any one of the preceding claims, further comprising a step of filtering the impulse response by comparing each peak with a predetermined threshold.

7. The method for characterising a transmission line according to any one of the preceding claims, further comprising a deconvolution step applied to the impulse response.

8. The method for characterising a transmission line according to any one of the preceding claims, further comprising a step of characterising a fault associated with at least one impedance discontinuity based on its characteristic impedance.

9. The method for characterising a transmission line according to any one of the preceding claims, further comprising a step of determining a continuous variation of characteristic impedance along the transmission line based on the determined characteristic impedances and on a model.

10. A computer program comprising instructions that cause the system according to claim 12 to execute the method for characterising a transmission line according to any one of the preceding claims.

11. A processor-readable storage medium on which the computer program according to claim 10 is stored.

12. A system for characterising a transmission line comprising a reference signal generator (GS) configured to inject a reference signal into a transmission line (CA) at an injection point, an item of measurement equipment (MI) configured to measure the back-propagated signal at a measurement point and a processing unit (MC); with the system being configured to execute the steps of the method according to any one of claims 1 to 9.

$$\Gamma_1 = \frac{Z_{c2} - Z_{c1}}{Z_{c2} + Z_{c1}}$$

$$\Gamma_2 = \frac{Z_{c1} - Z_{c2}}{Z_{c1} + Z_{c2}}$$

FIG.1

EP 4 001 934 B1

FIG.2

Mesure réponse
impulsionnelle — 301

Correction
amplitude pics

305

Identification pics
primaires et
secondaires — 302

Détermination
coefficient de réflexion
pics primaires — 303

Estimation coefficient
d'atténuation — 304

Suppression pics
secondaires — 306

Détermination
impédance
caractéristique — 307

# FIG.3

FIG.4

FIG.5

FIG.6

**EP 4 001 934 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- FR 2964746 A1
- US 2005234661 A1
- EP 1477820 A2
- FR 3034203

### Littérature non-brevet citée dans la description

- **LOETE, F. ; ZHANG, Q. ; SORINE, M.** Inverse Scattering Experiments for electric cable soft fault diagnosis and connector location. *Piers,* 2012, 1932-1936
- **LOETE, F. ; ZHANG, Q. ; SORINE, M.** Experimental Validation of the Inverse Scattering Method for Distributed Characteristic Impédance Estimation. *IEEE Transactions on Antennas and Propagation,* 2015, vol. 63 (6), 2532-2538
- Développement d'une nouvelle méthode de détermination des profils de teneur en eau dans les sols par inversion d'un signal TDR. **LUIZ ANTONIO PEREIRA DOS SANTOS.** thèse. université Joseph Fourier